Europäisches Patentamt

European Patent Office

Office européen des brevets

(11) Publication number: **0 416 889 A2**

# EUROPEAN PATENT APPLICATION

(21) Application number: 90309701.2

(51) Int. Cl.5: **H03D 7/14**

(22) Date of filing: 05.09.90

(30) Priority: 08.09.89 GB 8920335

(43) Date of publication of application:
13.03.91 Bulletin 91/11

(84) Designated Contracting States:
DE ES FR GB IT NL

(71) Applicant: LSI LOGIC EUROPE PLC
Grenville Place, The Ring
Bracknell, Berkshire RG12 1BP(GB)

(72) Inventor: Atkinson, Simon
36 Rectory Lane North
Leybourne, Kent ME19 5RA(GB)

(74) Representative: Thomson, Roger Bruce et al
W P THOMPSON & CO, Eastcheap House,
Central Approach
Letchworth Hertfordshire SG6 3DS(GB)

(54) Frequency mixers.

(57) A frequency mixer, especially for radio frequency transmission systems, comprises an emitter-coupled transistor pair ($T_1$, $T_2$) in which an input signal ($V_i$) and a local oscillator signal (LO) are mixed on the emitters and are translated to the collectors of the transistor pair at an intermediate frequency regardless of the size of the input signal. The mixer can operate as a square law mixer or as a switching mixer.

FIG.3

This invention relates to frequency mixers and is particularly concerned with wideband, high level mixers. The present invention is particularly appropriate for use in radio receiver/transmission apparatus and systems, although it should be understood that the mixer of the present invention is not limited to this particular application.

Frequency mixers are an essential component of radio receiver transmission systems. The key parameters which are used as figures of merit for such mixers are:
- noise figure
- linearity
- power consumption
- bandwidth

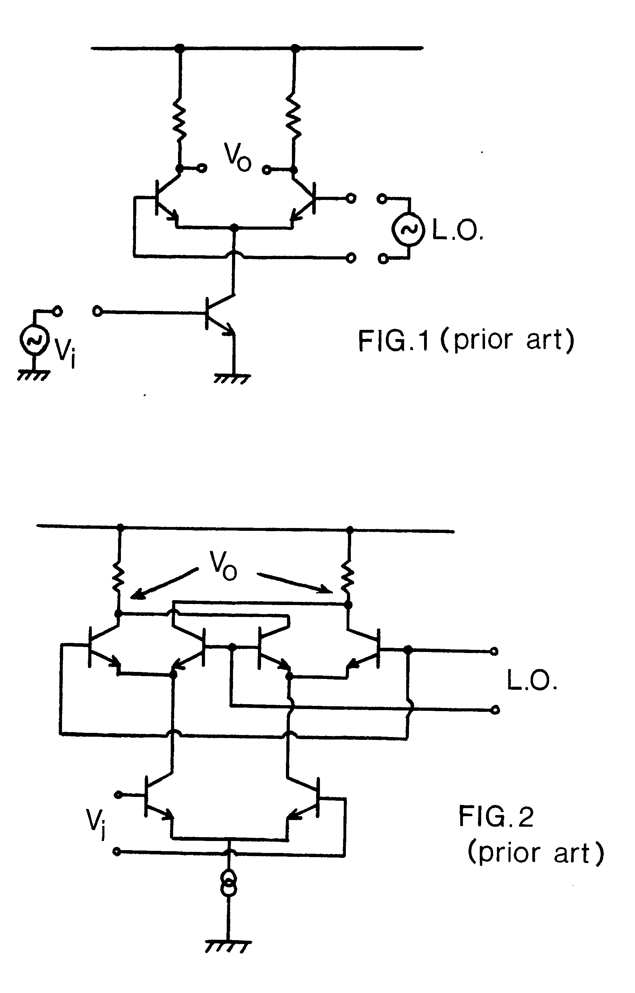

Examples of two known frequency mixers are shown in Figures 1 and 2 of the accompanying drawings. The mixer shown in Figure 1 is a single balanced mixer, whereas the mixer shown in Figure 2 is a double balanced mixer. In each case the mixer comprises a pair of transistors having coupled emitters. The input signal $V_i$ is fed to the coupled emitters, a local oscillator signal is fed to the bases of the transistors, and the output $V_o$ is taken from the collectors of the transistor pair or pairs. The disadvantages of such known mixers are primarily due to poor linearity and high power consumption.

It is an object of the present invention to provide a frequency mixer which shows improvement over the prior art mixers in terms of at least one of the parameters of noise, linearity, power consumption and bandwidth.

In accordance with one aspect of the present invention there is provided a frequency mixer comprising an emitter-coupled transistor pair in which an input signal and a local oscillator signal are mixed on the emitters and are translated to the collectors of the transistor pair at an intermediate frequency regardless of the size of the input signal.

In accordance with a further aspect of the present invention there is provided a frequency mixer comprising a pair of emitter-coupled transistors to which is supplied a high frequency signal and a local oscillator signal and from which an intermediate frequency output is taken, wherein the mixer changes from operating as a square law mixer to operating as a switching mixer in dependence upon the local oscillator signal and/or the high frequency input signal.

In accordance with a further aspect of the present invention there is provided a frequency mixer comprising a pair of emitter-coupled transistors to which is fed a high frequency signal and a local oscillator signal, and from which an intermediate frequency signal output is taken, wherein the mixer includes biassing means which enable the mixer to function as a switching mixer with switching of the mixer between on and off states being sequential about a biassing point.

In order that the present invention may be more fully understood, one presently preferred embodiment of frequency mixer in accordance with the invention will now be described by way of example and with reference to the accompanying drawings, in which:

Fig. 1 shows one known frequency mixer circuit;

Fig. 2 shows another known frequency mixer circuit;

Fig. 3 shows an embodiment of a frequency mixer circuit in accordance with the present invention; and,

Fig. 4 is a schematic illustration of the functioning of the frequency mixer as a switching mixer.

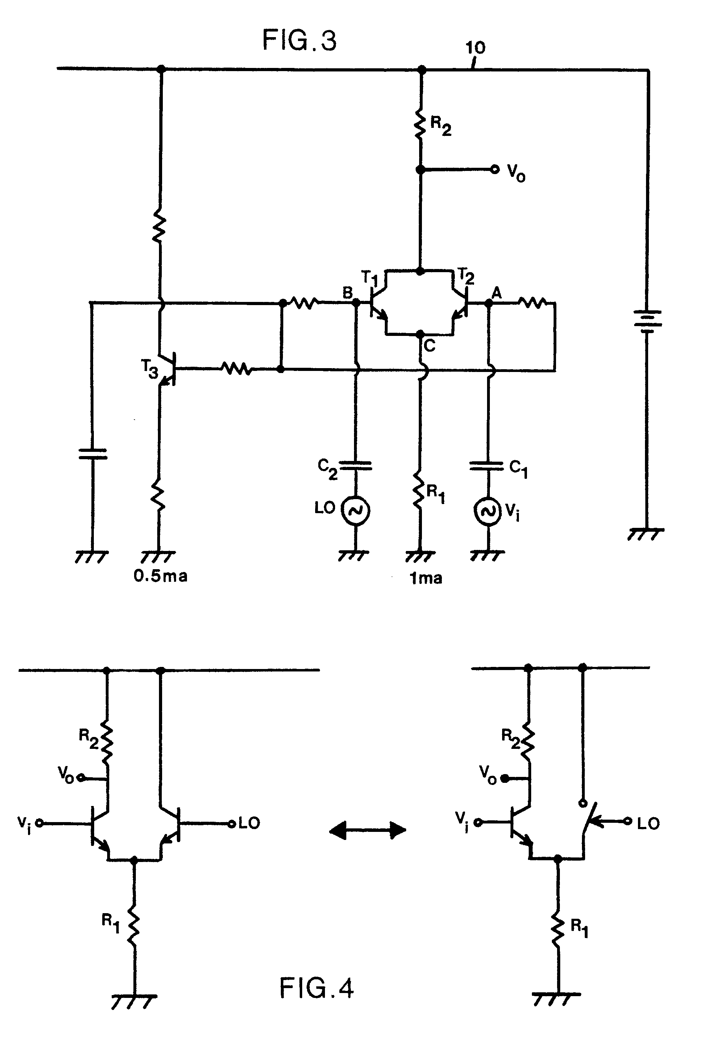

Referring to Fig. 3, the frequency mixer comprises a pair of transistors $T_1$ and $T_2$ which have their emitters coupled and connected via a resistance $R_1$ to ground. Reference C indicates a terminal connection point between one side of the resistance $R_1$ and the emitters. To the base of transistor $T_2$ is fed an rf input signal $V_i$, via point A. To the base of transistor $T_1$ is fed a signal from a local oscillator LO, via point B. A suitable capacitance $C_1$, $C_2$ is provided in each line to terminals A and B. The collectors of the transistors $T_1$ and $T_2$ are connected together and via a resistance $R_2$ to a rail 10. An intermediate frequency output $V_o$ is taken from between the common collectors and resistance $R_2$.

For mixers of this type, the local oscillator frequency and the input signal frequency have values typically up to 2 gigahertz, with the intermediate frequency having a value typically of up to 400 MHz.

The mixer circuit also includes biassing circuitry, in order to enable the mixer to operate as a switching mixer under certain conditions. The bias circuitry which comprises a transistor $T_3$ and appropriate resistance and capacitance components is connected to terminals A and B.

The frequency mixer of the present invention functions both as a square law mixer and as a switching mixer. In terms of square law operation, it is possible to show that for small input signals the AC voltage $V_{(C)}$ at terminal C is proportional to the square of the differential input voltage at terminals A and B. In other words:

$$V_{(C)} \propto [V_{(A)} - V_{(B)}]^2$$

If $V_{(A)}$ is the input signal voltage $= A \sin\omega_1 t$

2

and $V_{(B)}$ is the local oscillator voltage = $B \sin\omega_2 t$
Then,

$$V_{(C)} \alpha [A \sin \omega_1 t - B \sin\omega_2 t]^2$$
$$= A^2 \sin^2\omega_1 t + B^2 \sin^2\omega_2 t - 2AB\sin\omega_1 t \sin\omega_2 t$$
$$= \frac{A^2}{2} - \frac{A^2\cos 2\omega_1 t}{2} + \frac{B^2}{2} - \frac{B^2\cos 2\omega_2 t}{2}$$
$$- AB\cos(\omega_1 - \omega_2)t + AB\cos(\omega_1 + \omega_2)t$$

Thus, the resultant signal at terminal C contains sum and difference frequencies and second harmonics of the input signals. The frequency components of interest for a mixer are

$AB\cos(\omega_1 - \omega_2)t + AB\cos(\omega_1 + \omega_2)t$

This voltage at terminal C will modulate the current through resistance $R_1$ and, for the required components,

$$i \; \alpha \; \frac{AB\cos(\omega_1 + \omega_2)t - AB\cos(\omega_1 - \omega_2)t}{R_1}$$

Thus, at the output

$V_0 \; \alpha \; \frac{R2}{R1} [AB\cos(\omega_1 + \omega_2)t - AB\cos(\omega_2 - \omega_2)t]$

In high frequency systems, such as radio systems, where one has frequencies of the order of gigahertz, the mixer is required to translate the input frequency to a lower, intermediate frequency. With the frequency mixer of the present invention the high frequency input signal $V_i$ and the local oscillator signal are mixed on the emitters of the transistors $T_1$ and $T_2$ and the mixed signal is translated to the collectors of the transistor pair at the intermediate frequency, regardless of the size of the input signal $V_i$. It is particularly advantageous that the translation of the intermediate frequency signal from the emitters to the collectors of the transistors occurs at the lower, intermediate frequency, and not at the high frequency of the input signal $V_i$. In this way the mixer exhibits very high bandwidth for a given power consumption. Because the mixer can operate as a square law mixer, the generation of odd order harmonics is very small. Thus, the third, fifth, etc. order intermodulation performance is considerably better than for the prior art mixer shown in Fig.1 for example. Typically, the mixer shown in Fig. 3 gives an improvement of 15 dB in the third order input intercept point over the single balanced mixer shown in Fig. 1, with no degradation in noise performance.

As mentioned above, the frequency mixer of the present invention operates also as a switching mixer. This is illustrated schematically in Fig. 4. The mixer effectively switches on and off and in the off condition is in a "no current state". As the local oscillator signal increases and/or as the rf signal increases, so the frequency mixer changes from functioning as a square law mixer to functioning as a switching mixer. The mixer can be thought of as a heavily degenerated common-emitter amplifier whose input signal is modulated "on" and "off" by the presence of the oscillator signal. This generates sum and difference frequencies as before, but the input signal is also present at the output. The biassing circuitry which is incorporated in the frequency mixer of the present invention enables the switching to be effected appropriately. It is desirable that the switching should be sequential about the biassing point. Both the intermodulation and the bandwidth performance of the mixer are very good when operating as a switching mixer.

The particular circuit of the frequency mixer shown in the accompanying drawings is given by way of example only and should not be regarded as limiting the scope of the invention. For example, the resistance $R_1$ could alternatively be an inductor. The particular values of resistance for example will be chosen in accordance with the particular circuit requirements, although the ratio of the values of resistance $R_1$ and resistance $R_2$ is an important factor in that this ratio will set the conversion gain of the system.

**Claims**

1. A frequency mixer comprising a pair of transistors having their emitters coupled together, input means to connect an input signal to one of said transistors, and a local oscillator, characterised in that the local oscillator provides a signal to the other of said transistors, and in that the input signal and the oscillator signal are mixed on the emitters and are translated to the collectors of the transistor pair at an intermediate frequency regardless of the size of the input signal.

2. A frequency mixer as claimed in claim 1, characterised in that the collectors of the transistors are coupled together and to an output terminal.

3. A frequency mixer as claimed in claim 1 or 2, characterised in that the input signal is supplied to the base of said one transistor and the oscillator signal is supplied to the base of said other transistor.

4. A frequency mixer as claimed in claim 1, 2 or 3, characterised by output means connected to the collectors of the transistors, wherein the signal at the output means is at a frequency intermediate the input frequency and the oscillator frequency, and wherein the mixer changes from operating as a square law mixer to operating as a switching mixer in dependence upon the local oscillator signal.

5. A frequency mixer as claimed in claim 1, 2 or 3, characterised by output means connected to the collectors of the transistors, wherein the signal at the output means is at a frequency intermediate the input frequency and the oscillator frequency, and wherein the mixer changes from operating as a square law mixer to operating as a switching mixer in dependence on the magnitude of the input signal.

6. A frequency mixer as claimed in claim 4 or 5, characterised by biassing means connected to the said transistors to enable the mixer to function as a switching mixer with switching between "on" and "off" states being sequential about a biassing point.

7. A frequency mixer comprising a pair of transistors having their emitters coupled together, input means to connect an input signal to one of said transistors, a local oscillator providing a signal to the other of said transistors, and output means connected to the collectors of the transistors, wherein the signal at the output means is at a frequency intermediate the input frequency and the oscillator frequency, and wherein the mixer changes from operating as a square law mixer to operating as a switching mixer in dependence upon the local oscillator signal.

8. A frequency mixer comprising a pair of transistors having their emitters coupled together, input means to connect an input signal to one of said transistors, a local oscillator providing a signal to the other of said transistors, and output means connected to the collectors of the transistors, wherein the signal at the output means is at a frequency intermediate the input frequency and the oscillator frequency, and wherein the mixer changes from operating as a square law mixer to operating as a switching mixer in dependence on the magnitude of the input signal.

9. A frequency mixer comprising a pair of transistors having their emitters coupled together, input means to connect an input signal to one of said transistors, a local oscillator providing a signal to the other of said transistors, and output means connected to the collectors of the transistors, wherein the signal at the output means is at a frequency intermediate the input frequency and the oscillator frequency, and including biassing means connected to the said transistors to enable the mixer to function as a switching mixer with switching between "on" and "off" states being sequential about a biassing point.

FIG.1 (prior art)

FIG.2 (prior art)

# FIG.3

# FIG.4